Europäisches Patentamt

**European Patent Office**

**Office européen des brevets**

(19)

(11) Numéro de publication: **0 002 420**
A1

# DEMANDE DE BREVET EUROPEEN

(12)

(21) Numéro de dépôt: **78430008.9**

(22) Date de dépôt: **20.07.78**

(51) Int. Cl.²: **H 01 L 31/10**
**G 11 C 13/04, H 01 L 29/62**

(30) Priorité: **01.12.77 US 856477**

(43) Date de publication de la demande:
**13.06.79 Bulletin 79/12**

(84) Etats contractants désignés:
**DE FR GB**

(71) Demandeur: **International Business Machines
Corporation**

**Armonk, N.Y. 10504(US)**

(72) Inventeur: **DiMaria, Donelli Joseph
77 Carpenter Avenue
Mt. Kisco New York 10549(US)**

(72) Inventeur: **Young, Donald Reeder
14 Briarbrook Road
Ossining New York 10562(US)**

(74) Mandataire: **Klein, Daniel
COMPAGNIE IBM FRANCE Département de Propriété
Industrielle
F-06610 La Gaude(FR)**

(54) **Dispositif semi-conducteur du type transistor à effet de champ activé par la lumière et mémoire en résultant.**

(57) La présente invention concerne un dispositif à semi-conducteur activé par la lumière et, plus particulièrement, un transistor à effect de champ (FET), dont l'isolant de porte comprend des impuretés sensibles à la lumière.

Ce transistor à effet de champ (1) comprend un substrat semi-conducteur (2) muni de deux régions de source et de drain (3) et (4), et de leurs contacts (7) et (8), d'une couche diélectrique de porte (6) recouverte d'une électrode de porte conductrice (9), semi-transparente pour la lumière utilisée. Une couche de piégeage (10) est réalisée par implantation d'ions d'arsenic ou de phosphore dans cette couche diélectrique. Selon la nature de la tension de polarisation appliquée à l'électrode (9), en présence de la lumière les ions se chargent ou se déchargent, caractérisant l'absence ou la présence d'une information dans le dispositif.

Ce dispositif peut donc être utilisé comme élément dans une mémoire activée par la lumière.

FIG.1

1

# DISPOSITIF SEMI-CONDUCTEUR DU TYPE TRANSISTOR
# A EFFET DE CHAMP ACTIVE PAR LA LUMIERE
# ET MEMOIRE EN RESULTANT

## Description

### Domaine technique

La présente invention concerne un dispositif à semi-conducteur activé par la lumière et, plus particulièrement, un transistor à effet de champ (FET), dont l'isolant de porte comprend des impuretés sensibles à la lumière. Ce dispositif est susceptible d'être utilisé dans une mémoire.

### Etat de la technique antérieure

Les dispositifs de l'art antérieur qui comportent des couches de piégeage comprennent généralement un corps en silicium sur lequel est disposée une première couche de dioxyde de silicium, un film métallique ou un film de polysilicium fortement dopé, et une seconde couche de dioxyde de silicium. Dans ces dispositifs, le film de métal ou de polysilicium fait fonction de couche de piégeage. Ces dispositifs présentent de graves inconvénients. Par exemple, en raison du fait que le film de métal ou de polysilicium qui est utilisé pour emmagasiner la charge est une couche conductrice, les imperfec-

2

tions que peut comporter l'isolant ont pour effet de décharger l'ensemble de la couche. C'est là un problème particulier car la seconde couche de dioxyde de silicium déposée sur le film métallique présente généralement des caractéristiques inférieures; par exemple elle possède une médiocre qualité diélectrique. De ce fait, le film de dioxyde de silicium tend à piéger une charge plus importante qu'un film de dioxyde de silicium thermique le ferait normalement. Par ailleurs, la couche métallique qui est utilisée dans les dispositifs de l'art antérieur est généralement opaque à la lumière et ne peut donc pas être chargée au moyen d'une émission d'électrons, provoquée par des moyens optiques, depuis le corps de silicium au niveau de l'interface silicium-dioxyde de silicium.

## Exposé de l'invention

Selon la présente invention, une couche de piégeage peut être réalisée dans le film de dioxyde de silicium qui est contigü au corps en silicium. Cela rend inutile l'emploi d'une couche de métal ou d'une couche de polysilicium fortement dopé et on supprime ainsi les inconvénients que présente une telle couche. Le dispositif de la présente invention peut être activé par la lumière, c'est-à-dire que certaines de ses caractéristiques de fonctionnement (conduction du canal ...) peuvent être modifiées par elle.

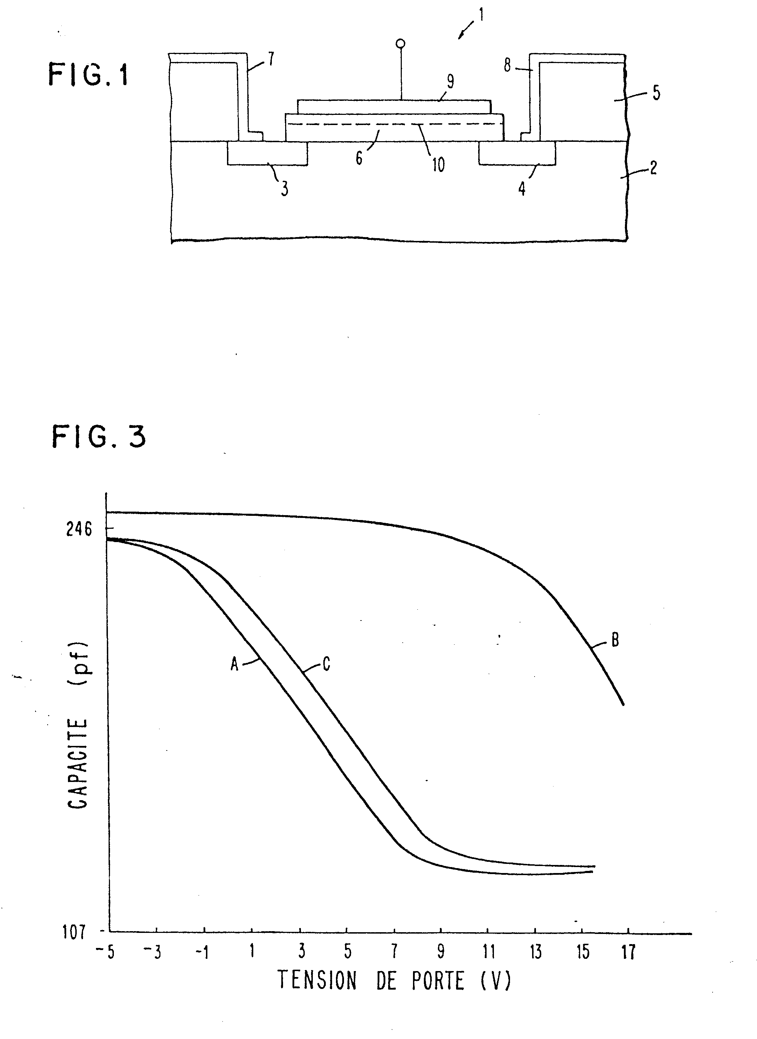

La présente invention décrit plus précisément un dispositif de type FET activé par la lumière (ci-après désigné dispositif LAS) et son application comme élément ou cellule de mémoire. Ce dispositif se compose d'un transistor à effet de champ classique du type métal-dioxyde de silicium-silicium (MOSFET) dont la couche de porte en $SiO_2$ comporte une couche de piégeage des

3

charges. D'autres types de dispositifs semi-conducteurs peuvent également être employés. Un transistor MOSFET à canal N est représenté à titre d'exemple sur la figure 1, mais un dispositif à canal P pourrait également être employé. Cette couche de piégeage comporte des impuretés sensibles à des radiations notamment à la lumière, des ions As ou P par exemple. Les informations sont emmagasinées dans le dispositif en exposant ce dernier à une source de lumière. La lumière provoque la charge ou la décharge des ions d'impureté.

Un objet de la présente invention est donc de fournir un dispositif du type FET, pouvant être utilisé comme élément d'une mémoire, en particulier sous la commande de la lumière.

Un autre objet de l'invention est de fournir un procédé de réalisation d'un tel dispositif FET.

D'autres objets, caractéristiques et avantages de la présente invention ressortiront mieux de l'exposé qui suit, fait en référence aux dessins annexés à ce texte, qui représentent un mode de réalisation préféré de celle-ci.

Brève description des figures

La figure 1 représente un dispositif LAS conforme à l'invention.

Les figures 2A à 2C sont des diagrammes des bandes d'énergie du dispositif LAS de la figure 1 lorsque celui-ci est exposé à la lumière.

La figure 3 est un diagramme représentant la caractéris-

4

tique capacité-tension du type haute fréquence en fonction de la tension de porte appliquée au dispositif LAS.

## Description de l'invention

On a représenté sur la figure 1 un transistor FET à porte isolée du type à canal N fabriqué conformément à une réalisation préférée de l'invention. Ce transistor se compose d'un substrat semi-conducteur 2 en silicium monocristallin de type P dans lequel sont formées à partir de sa surface supérieure deux régions de type N 3 et 4 qui sont séparées l'une de l'autre et respectivement désignées ci-après, dans un but de commodité, région de source et région de drain.

La surface supérieure du substrat 2 est recouverte d'une couche isolante diélectrique 5 qui est partiellement éliminée au niveau des régions 3 et 4 et qui se compose de dioxyde de silicium obtenu par croissance thermique. La couche 6 qui recouvre partiellement les régions 3 et 4 est également une couche isolante en dioxyde de silicium obtenue par croissance thermique. Des contacts métalliques 7 et 8 sont disposés sur la couche 5 et constituent respectivement le contact de source et le contact de drain. La région 6 est recouverte d'un métal semi-transparent, Al ou Au par exemple, constituant l'électrode de porte 9. La région 6 comporte des ions d'une impureté sensible à la lumière; cette région est représentée par la ligne en pointillé 10 et elle constitue la caractéristique principale de la présente invention.

On a constaté que lorsque des impuretés sensibles à la lumière (As et P, par exemple) étaient disposées dans

5

la région 6, elles constituaient des sites de piégeage d'électrons. Les électrons ainsi piégés peuvent être libérés au moyen d'une radiation lumineuse d'énergie suffisante, selon l'équation:

$$\nu > q\, \phi_\rho / h$$

où $\nu$ est la fréquence,

$q$ est la charge électronique,

$h$ est la constante de Planck, et

$\phi_\rho$ a une valeur d'environ 5 volts.

Cette condition est satisfaite lorsque la valeur de $\nu$ est supérieure à $1,21 \times 10^{15}$ Hz ou lorsque la longueur d'onde de la lumière ($\lambda$) est inférieure à $2,48 \times 10^{-5}$ cm. Une lumière qui présente cette énergie permet d'injecter les électrons, depuis le Si, dans la couche de $SiO_2$ constituant la porte. De même, lorsque l'électrode de porte est en Al, une telle lumière permet également d'injecter des électrons, depuis l'Aluminium, dans la couche de $SiO_2$ constituant la porte, selon la polarité du champ. Lors de l'application d'un champ électrique, les électrons traversent la couche de $SiO_2$ constituant la porte, une partie de ces électrons étant piégée au niveau des impuretés (sites de piégeage). Pour que la lumière assure l'injection des électrons depuis l'interface $Al-SiO_2$ (la hauteur de la barrière de potentiel étant de 3,2 volts), il faut que: $\nu > 2,74 \times 10^{14}$ Hz ou que $\lambda < 3,88 \times 10^{-5}$ cm. S'il s'agit d'un interface $Si-SiO_2$ ( hauteur de la barrière de potentiel = 4,2 volts), il est nécessaire que: $\nu > 1,02 \times 10^{15}$ Hz ou que $\lambda < 2,95 \times 10^{-5}$ cm.

Dans ces conditions, avec une électrode de porte en Al, portée à une tension positive, il se produit une injection

6

depuis l'interface Si-SiO$_2$. Inversement, si une tension négative est appliquée, l'injection a lieu depuis l'interface Al-SiO$_2$.

Le dispositif représenté sur la figure 1 peut être réalisé au moyen de divers procédés connus.

On trouvera ci-après une rapide description de la fabrication d'un dispositif de type métal-oxyde-semi-conducteur utilisable dans la présente invention. Cette description est donnée à titre d'exemple, la fabrication des transistors à effet de champ étant bien connue.

Des substrats en silicium de type P présentant une orientation cristalline (100) et une résistivité de 0,1 $\Omega$.cm sont oxydés dans une atmosphère d'oxygène sec à 1000°C jusqu'à ce que des couches de SiO$_2$ d'une épaisseur d'environ 500 Å et 1400 Å soient obtenues. Des ions d'As ou de P sont implantés dans les couches de SiO$_2$ d'une épaisseur de 1400 Å. Les doses d'impureté peuvent varier entre $10^{11}$ et $10^{15}$ ions/cm$^2$ environ. Des doses de $3 \times 10^{12}$, $1 \times 10^{13}$ et $1 \times 10^{14}$ ions/cm$^2$ sont souhaitables dans le cas de l'As lorsque celui-ci est implanté à des énergies de 10 à 100 keV. Des doses de $1 \times 10^{13}$ ions/cm$^2$ sont souhaitables dans le cas du P à des énergies d'environ 40 keV. Les ions d'As et de P respectivement implantés à des énergies de 80 keV environ et 40 keV environ ont approximativement le même centroïde. (Pour la définition du centroïde, on se référa à la publication de DiMaria citée ci-après). L'implantation d'ions d'As dans la couche de SiO$_2$ d'une épaisseur de 500 Å s'effectue avec une dose de $1 \times 10^{13}$ ions/cm$^2$ et avec une énergie de 20 keV. Après l'implantation d'ions, les surfaces d'oxyde sont nettoyées en éliminant les hydrocarbones et les métaux au moyen de la technique dite de

7

Huang modifiée: sans la présence d'acide HF. A cet égard, on se reportera à l'article de E. A. Irene, intitulé "Effects of Trace Amounts of Water on the Thermal Oxidation of Silicon in Oxygen", paru dans la publication "J. Electrochem. Soc.", 121, 1613 (1974). Le dispositif ainsi traité est ensuite recuit à 1000°C dans une atmosphère d'azote pendant 30 minutes environ. L'objet de cette dernière opération est de pallier les détériorations résultant des radiations et du déplacement atomique. Des électrodes métalliques minces, par exemple en Al d'une épaisseur d'environ 130 Å, sont ensuite déposées sur l'isolant de porte. Ces électrodes recouvrent une région circulaire d'environ $5 \times 10^{-3}$ cm$^2$. Enfin, le dispositif est porté à une température d'environ 400°C dans un gaz de formation pendant 20 minutes environ.

Afin de déterminer l'état de la charge du dispositif LAS de la présente invention, des mesures de capacité-tension ont été effectuées de la façon préconisée dans l'ouvrage de A. S. Grove intitulé "Physics and Technology of Semiconductor Device", publié par Wiley, New York, 1967, chapitre 9. Des mesures des caractéristiques photo-courant-tension ont également été effectuées conformément à l'article de D.J. DiMaria intitulé "Determination of Insulator Bulk Trap Charge Density and Centroids from Photocurrent-Voltage Characteristics of MOS Structures", paru dans la publication "J. Appl. Phys.", 47, (9), page 4073, septembre 1976. Les décalages entre les courbes de capacité-tension de la figure 3 permettent une mesure du produit de la charge piégée par centimètre carré et du centroïde, ainsi qu'il est décrit de façon détaillée dans l'ouvrage précité de A. S. Grove. Les mesures des caractéristiques de photo-courant-tension décrites dans l'article précité

8

de D.J. DiMaria donnent le centroïde et la charge piégée indépendamment l'un de l'autre. Aux fins de ces mesures, des lampes au xénon et au deutérium ont été utilisées pour charger et décharger les électrons piégés. Un contact avec l'électrode métallique a été établi au moyen d'une sonde en tungstène poli d'un diamètre de 0,127mm. On a constaté que l'effet produit par l'ombre projetée par cette sonde de faible diamètre sur la région de porte activée par la lumière était négligeable. On notera que, bien que des sources de lumière ultraviolette aient été employées, on pourrait également se servir d'autres longueurs d'onde lumineuses en fonction de la sensibilité et de la nature du dopant.

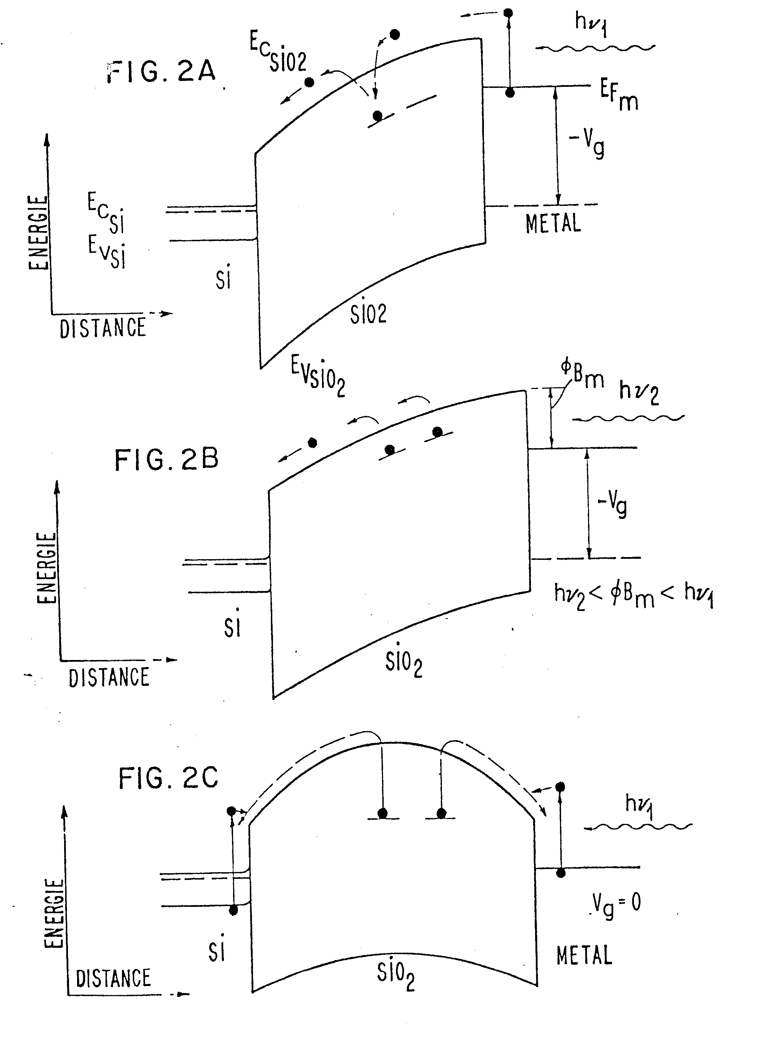

Divers ions implantés dans la couche en $SiO_2$ d'une structure du type MOS, tels que du P et de l'As, peuvent être chargés ou déchargés au moyen d'une lumière. Une lumière présentant une (ou plusieurs) énergie appropriée permet de procéder à une photoinduction d'électrons émanant soit du silicium soit du contact en Al dans la couche de $SiO_2$ pour des polarisations de porte positive et négative, respectivement. Certains de ces électrons sont piégés dans cette région, la probabilité pour que ce piégeage ait lieu est proportionnelle au produit du nombre de pièges vides par unité de surface, par la section de capture. Toutefois, la même énergie lumineuse qui est utilisée pour injecter les électrons à partir des contacts peut également les décharger au fur et à mesure qu'ils sont piégés, si l'énergie de photo-ionisation des électrons piégés est égale ou inférieure à l'énergie requise aux fins de l'injection. Ce processus est représenté sur la figure 2A. Si, pour une tension de polarisation donnée, la constante de temps associée au processus de capture est inférieure à celle qui est associée au processus de photo-ionisation, les pièges

se rempliront jusqu'à ce que le nombre d'électrons piégés atteigne une certaine valeur, déterminée par le rapport des constantes de temps de ce processus, en régime permanent. Cela constituerait une opération d'"écriture" effectuée dans le dispositif LAS. Pour que ce dernier fasse l'objet d'une opération d'"effacement" une fois chargé, la capture des électrons doit être supprimée et la photo-ionisation des électrons piégés favorisée. Ce résultat peut être obtenu en empêchant l'injection d'électrons depuis les contacts, en modifiant l'énergie lumineuse ou la tension appliquée pour une énergie lumineuse donnée, comme le montrent respectivement les figures 2B et 2C. Le processus représenté sur la figure 2B n'est applicable qu'aux électrons piégés présentant des énergies d'ionisation inférieures à celles requises aux fins d'une injection des porteurs depuis les contacts. Sur la figure 2C, où l'énergie d'ionisation des électrons piégés est égale ou supérieure à celle requise aux fins de l'injection des porteurs, le champ interne dû à la charge d'espace négative des pièges est utilisé pour bloquer la photo-injection depuis les contacts à une faible tension de polarisation de porte, tout en permettant la photo-ionisation.

La figure 3 représente à titre d'exemple des courbes de capacité-tension qui indiquent l'état de la charge d'un dispositif LAS après différentes étapes de son fonctionnement. Le dispositif du type MOS utilisé aux fins de cette figure comportait une couche de $SiO_2$ d'une épaisseur de 1400 Å dans laquelle des ions d'$As^+$ avaient été implantés avec une dose de $1 \times 10^{14}$ ions/$cm^2$ à 80 keV. La courbe A correspond à l'état non chargé. La courbe B correspond à l'état chargé, dans lequel le nombre d'électrons piégés dans la région implantée atteint une valeur obtenue en régime permanent qui est fonction de

0002420

10

l'énergie lumineuse (spectre intégral d'une lampe au deutérium) et de la tension de polarisation (-29 volts). Cela constitue l'opération d'"écriture". La courbe C correspond à l'état déchargé du dispositif après photo-ionisation à la même énergie lumineuse (spectre intégral d'une lampe au deutérium), mais à une tension de polarisation de porte différente (0 volt). Cela constitue l'opération d'"effacement".

Si l'on augmente le nombre de piéges associés aux ions implantés ou l'importance de la section de capture par rapport à la section de photo-ionisation, on diminue le temps requis aux fins d'une opération d'"écriture" dans le dispositif LAS de manière à atteindre un état de charge donné au moyen d'une photo-injection d'électrons depuis les contacts avec une lumière d'énergie hν pour une tension de polarisation donnée. La charge piégée en régime permanent dans le cas de l'opération d'"écriture" est associée à ces paramètres par l'expression:

$$n_t = N_t \left[ 1 + \frac{qF_\rho \sigma_\rho A}{I_\rho \sigma_c} \right]^{-1}$$

où $n_t$ est la densité en régime permanent en électrons piégés,

$N_t$ est le nombre total de piéges,

$F_\rho$ est le flux des photons,

$\sigma_\rho$ est la section de photo-ionisation,

$\sigma_c$ est la section de capture,

$I_\rho$ est le courant de photo-injection en régime permanent, et

$A$ est la surface du dispositif qui est activée par la lumière.

11

Ces paramètres ont été déterminés dans le cas d'une implantation d'ions d'As et de P. La section de photo-ionisation $\sigma_\rho$ est pratiquement la même pour les deux types d'ions avec des valeurs de $\sim 10^{-18}$ à $10^{-17}$ ions/cm$^2$ pour des énergies lumineuses variant entre 3,5 et 5,5 eV. On notera que des énergies lumineuses > 4 eV et 3,2 eV sont respectivement nécessaires pour procéder à une photo-injection à partir des contacts en Si et Al. Les sections de capture pour les sites de piégeage diffèrent de façon importante selon qu'il s'agit d'ions implantés d'As ou de P, les valeurs respectives étant $\simeq 1 \times 10^{-15}$ ions/cm$^2$ et $\simeq 1 \times 10^{-17}$ ions/cm$^2$. Les dispositifs LAS qui ont fait l'objet d'implantations d'ions d'As se prêtent donc plus facilement à des opérations d'"écriture". En utilisant le champ interne résultant de la charge négative piégée, la chute de tension dans la couche de SiO$_2$ étant nulle (voir figure 2C), des dispositifs LAS, dans lesquels des ions d'As ou de P ont été implantés, peuvent faire l'objet d'opérations d'"effacement" au même rythme pour des charges négatives piégées équivalentes en raison du fait que les $\sigma_\rho$ sont identiques. La constante de temps de photo-ionisation équivaut à $(F_\rho \sigma_\rho)^{-1}$. Le fait de faire passer la dose d'As de $3 \times 10^{12}$ à $1 \times 10^{14}$ ions/cm$^2$ (ce qui entraîne une modification correspondante de la densité des piéges) a provoqué une diminution du temps de charge du dispositif LAS.

Outre le changement apporté aux valeurs des facteurs $N_t$, $\sigma_\rho$ et/ou $\sigma_c$, une charge plus rapide a été obtenue en augmentant la valeur de $I_\rho$. Ce résultat a été atteint en augmentant la polarisation de porte et par conséquent en permettant à un plus grand nombre d'électrons "chauds" de franchir la barrière de Schottky à l'interface de photo-injection. Le courant interne de photo-émission

12

pourrait également être augmenté en augmentant l'intensité lumineuse, $(I_\rho \alpha F_\rho)$, mais cela se traduirait par une augmentation de la vitesse de photo-ionisation qui est également proportionnelle à $F_\rho$.

Sur la figure 3, la comparaison entre la courbe C et la courbe A montre qu'une charge négative correspondant à un potentiel d'environ 1 volt demeure dans l'oxyde après l'étape de photo-ionisation ("effacement"). Toutefois, une commutation reproductible du dispositif LAS n'a pu être obtenue entre les courbes C et B de la figure 3 pendant des cycles ultérieurs d'"écriture" et d'"effacement". Pour l'étape d'"effacement", des tensions de polarisation variant entre 0 volt et -1 volt ont été appliquées au dispositif LAS afin d'obtenir une chute de tension nulle dans le film. Dans le cas de dispositifs MOS en Si du type P présentant une résistivité de 0,1 $\Omega$.cm et comportant des électrodes de porte en Al, le champ interne dû à la différence entre les fonctions de travail de l'Al et du Si est d'environ -0,9 volt (et d'environ 0 volt dans le cas de dispositifs en Si du type N).

La technique de détermination du photo-courant en fonction de la tension a été utilisée pour montrer que le centroïde de la charge négative piégée et la distribution des ions implantés (As ou P) sont identiques. En ce servant de cette technique en différents points du processus de photo-ionisation pour suivre l'évolution du centroïde et de la charge piégée, on a clairement mis en évidence le fait que cette charge était retirée du film de $SiO_2$.

On a constaté que les dispositifs LAS présentaient une fuite peu importante de leur charge après avoir été

13

stockés pendant un certain temps dans l'obscurité, la porte et le substrat étant court-circuités ou flottants.

La façon plus plus pratique et la plus commode de faire fonctionner le dispositif LAS est d'utiliser une source lumineuse présentant une ou plusieurs énergies fixes (telle qu'une petite lampe de 60 watts au deutérium), puis à modifier la tension de polarisation pour effectuer une opération d'"écriture" ou d'"effacement". Ainsi que le démontre la description faite ci-dessus, si l'on augmente le nombre de pièges en employant des doses d'ions plus importantes ou en augmentant le rapport de la section de capture à la section de photo-ionisation, on augmente la vitesse de l'opération d'"écriture", jusqu'à un état de charge donné. La vitesse de l'opération d'"effacement" peut être augmentée en utilisant des ions qui donnent des pièges de moindre profondeur (et par conséquent des sections de photo-ionisation plus importantes). Ces derniers pièges doivent cependant permettre de procéder à la charge (opération d'"écriture"), et offrir une bonne conservation.

Bien que l'on ait décrit dans ce qui précède et représenté sur les dessins les caractéristiques essentielles de l'invention appliquées à un mode de réalisation préféré de celle-ci, il est évident que l'homme de l'art peut y apporter toutes modifications de forme ou de détail qu'il juge utiles, sans pour autant sortir du cadre de ladite invention.

0002420

14

## REVENDICATIONS

1. Dispositif semi-conducteur du type transistor à effet de champ caractérisé en ce que la couche diélectrique de porte comporte des impuretés sensibles à des radiations et des moyens pour injecter des électrons dans la couche diélectrique et modifier la charge des impuretés.

2. Dispositif semi-conducteur selon la revendication 1 caractérisé en ce que les radiations sont des radiations lumineuses et que l'électrode de porte est transparente pour ces dernières.

3. Dispositif semi-conducteur selon la revendication 2 caractérisé en ce que l'électrode de porte est réalisée à partir d'une couche semi-transparente de métal.

4. Dispositif semi-conducteur selon l'une des revendications 1 à 3 caractérisé en ce que les impuretés sont choisies dans le groupe comprenant l'arsenic (As) et le phosphore (P).

5. Dispositif semi-conducteur selon la revendication 4 caractérisé en ce que la dose d'impuretés est comprise entre $10^{11}$ et $10^{15}$ ions/cm$^2$.

0002420

15

6. Dispositif semi-conducteur selon la revendication 5 caractérisé en ce que la dose d'impuretés est comprise entre $3 \times 10^{12}$ et $1 \times 10^{14}$ ions/cm$^2$.

7. Dispositif semi-conducteur selon l'une quelconque des revendications 2 à 6 caractérisé en ce que la longueur d'onde des radiations est comprise entre 2250 et 4000 $\overset{o}{A}$.

8. Mémoire à semi-conducteur caractérisée en ce qu'elle comporte au moins un dispositif tel que défini par l'une des revendications 1 à 7.

FIG.1

FIG.3

CAPACITE (pf)

246

107

−5 −3 −1 1 3 5 7 9 11 13 15 17

TENSION DE PORTE (V)

FIG. 2A

FIG. 2B

FIG. 2C

**Office européen des brevets**

**RAPPORT DE RECHERCHE EUROPEENNE**

| Catégorie | Citation du document avec indication, en cas de besoin, des parties pertinentes | Revendication concernée |
|---|---|---|
| | XEROX DISCLOSURE JOURNAL, vol. 1, no. 1, janvier 1976, Stamford Connecticut, USA K. OKUMURA "Information Storage Device" page 33. <br> * Page 33 * | 1 |
| | US - A - 4 057 819 (A.E. OWEN and J. MAVOR) <br> * Revendications et figures * | 1 |
| | FR - A - 2 286 469 (SIEMENS) <br> * Revendications et figures * | 1 |
| | DE - A - 2 415 425 (SIEMENS) <br> * Revendications et figure 1 * | 1 |
| | US - A - 3 860 916 (AGENCY OF INDUSTRIAL SCIENCE AND TECHNOLOGY) <br> * Revendications * | 1 |
| | US - A - 3 950 738 (AGENCY OF INDUSTRIAL SCIENCE AND TECHNOLOGY) <br> * Revendications * | 1 |
| | FR - A - 1 389 820 (MATSUSHITA) <br> * Résumé et figures * | 1 |

**DOCUMENTS CONSIDERES COMME PERTINENTS**

**CLASSEMENT DE LA DEMANDE (Int. Cl.²)**

H 01 L 31/10
G 11 C 13/04
H 01 L 29/62

**DOMAINES TECHNIQUES RECHERCHES (Int. Cl.²)**

H 01 L 31/10
G 11 C 13/04
G 11 C 11/34
H 01 L 29/62

**CATEGORIE DES DOCUMENTS CITES**

X: particulièrement pertinent
A: arrière-plan technologique
O: divulgation non-écrite
P: document intercalaire
T: théorie ou principe à la base de l'invention
E: demande faisant interférence
D: document cité dans la demande
L: document cité pour d'autres raisons
&: membre de la même famille, document correspondant

Le présent rapport de recherche a été établi pour toutes les revendications

| Lieu de la recherche | Date d'achèvement de la recherche | Examinateur |
|---|---|---|
| La Haye | 08-03-1979 | HASLAUER |

OEB Form 1503.1  06.78